# EUROPEAN PATENT APPLICATION

(11) **EP 4 734 324 A1**
(43) Date of publication of application: **29.04.2026**
(21) Application number: 24872752.1
(22) Date of filing: 29.08.2024
(51) Int. Cl.: H02J 7/00, G01R 31/392, G01R 27/02, G01R 31/3842, G01R 31/367, H01M 10/44, H01M 10/48

(54) **CHARGING MANAGEMENT DEVICE AND OPERATION METHOD THEREOF**

(30) Priority: 25.09.2023 KR 20230128266
(71) Applicant: LG Energy Solution, Ltd., Seoul 07335 (KR)
(72) Inventor: KIM, You Na, Daejeon 34122 (KR); LEE, Sol Nip, Daejeon 34122 (KR); KOH, Dong Wook, Daejeon 34122 (KR)
(74) Representative: Plasseraud IP
(86) International application number: PCT/KR2024/012947
(87) International publication number: WO 2025/071044

(57) **Abstract**

The charging management apparatus according to an embodiment disclosed in this document may include a parameter extraction unit configured to extract a plurality of parameters related to a battery cell, a key parameter selection unit configured to select one or more key parameters from the plurality of parameters, and a depth prediction unit configured to predict the charging depth of the battery cell based on the key parameters.

## Description

### TECHNICAL FIELD

### CROSS REFERENCE TO RELATED APPLICATION

This application claims priority to Korean Patent Application No. 10-2023-0128266, filed September 25, 2023, the entire contents of which is incorporated herein for all purposes by this reference.

### TECHNICAL FIELD

The embodiments disclosed in this document relate to a charging management apparatus and operating method thereof.

### BACKGROUND ART

Recently, research and development on secondary batteries has been actively conducted. Here, secondary batteries refer to rechargeable batteries, encompassing traditional Ni/Cd batteries, Ni/MH batteries, and modern lithium-ion batteries. Recently, their use has expanded to power electric vehicles, gaining attention as a next-generation energy storage medium.

Electric vehicles draw power by charging their battery cells from external electrical sources, which are then discharged to drive motors and provide propulsion. Throughout production and usage, battery cells experience numerous charge and discharge cycles, leading to internal deformation and degradation that can alter their physical and chemical properties. This can result in issues such as internal and external short circuits, venting caused by lithium deposition, or under-voltage conditions where the battery cell's voltage falls below a critical threshold. To mitigate the effects of battery deterioration and degradation, there is a need for technology that can effectively manage the charging operation of the battery cells.

### DISCLOSURE

### TECHNICAL PROBLEM

It is an object of the embodiments disclosed in this document to provide a charging management apparatus and an operating method thereof that are capable of managing rapid charging by predicting the rapid charging depth for minimizing battery degradation.

It is an object of the embodiments disclosed in this document to provide a charging management apparatus and an operating method thereof that are capable of managing rapid charging by predicting the rapid charging depth for minimizing battery deterioration in consideration of the degradation level of the battery.

The technical objects of the embodiments disclosed in this document are not limited to the aforesaid, and other objects not described herein with be clearly understood by those skilled in the art from the descriptions below.

### TECHNICAL SOLUTION

A charging management apparatus according to an embodiment disclosed in this document may include a parameter extraction unit configured to extract a plurality of parameters related to a battery cell, a key parameter selection unit configured to select one or more key parameters from the plurality of parameters, and a depth prediction unit configured to predict the charging depth of the battery cell based on the key parameters.

According to an embodiment, the key parameter selection unit may modify the value of at least one parameter among the plurality of parameters within a target range in an environment where the battery cell is charged based on a predetermined temperature and a predetermined C-rate, and select the at least one parameter as the key parameter when the amount of change in a state value of the battery cell, based on the modified value of the at least one parameter, is equal to or greater than a threshold value.

According to an embodiment, the target range may be a range of values of the at least one parameter corresponding to a first degradation level of the battery cell.

According to an embodiment, the key parameter selection unit may determine the first degradation level based on an increase in resistance or a decrease in voltage of the battery cell during a discharge period.

According to an embodiment, the key parameter may include at least one of diffusivity, tortuosity, and rate constant related to an anode of the battery cell.

According to an embodiment, the depth prediction unit may estimate the value of the key parameter based on the ohmic resistance and polarization resistance of the battery cell during the discharge period, and predict the charging depth of the battery cell based on the estimated value of the key parameter.

According to an embodiment, the depth prediction unit may estimate the value of the key parameter by giving a greater weight to the polarization resistance of the battery cell than to the ohmic resistance of the battery cell.

According to an embodiment, the depth prediction unit may calculate a C-rate profile corresponding to the state of charge (SOC) of the battery cell based on the estimated value of the key parameter, and predict the charging depth of the battery cell based on the profile.

A charging management method according to an embodiment disclosed in this document may include extracting a plurality of parameters related to a battery cell, selecting one or more key parameters from among the plurality of parameters, and predicting the charging depth of the battery cell based on the key parameters.

According to an embodiment, the selecting of one or more key parameters from among the plurality of parameters may include modifying the value of at least one parameter among the plurality of parameters within a target range in an environment where the battery cell is charged based on a predetermined temperature and a predetermined C-rate, and selecting the at least one parameter as the key parameter when the amount of change in a state value of the battery cell, based on the modified value of the at least one parameter, is equal to or greater than a threshold value.

According to an embodiment, the target range may be a range of values of the at least one parameter corresponding to a first degradation level of the battery cell.

According to an embodiment, the selecting of one or more key parameters from among the plurality of parameters may further include determining the first degradation level based on an increase in resistance or a decrease in voltage of the battery cell during a discharge period.

According to an embodiment, the key parameter may include at least one of diffusivity, tortuosity, and rate constant related to an anode of the battery cell.

According to an embodiment, the predicting of the charging depth of the battery cell may include estimating the value of the key parameter based on the ohmic resistance and polarization resistance of the battery cell during the discharge period; and predicting the charging depth of the battery cell based on the estimated value of the key parameter.

According to an embodiment, the predicting of the charging depth of the battery cell may include estimating the value of the key parameter by giving a greater weight to the polarization resistance of the battery cell than to the ohmic resistance of the battery cell.

According to an embodiment, the predicting of the charging depth of the battery cell may further include calculating a C-rate profile corresponding to the state of charge (SOC) of the battery cell based on the estimated value of the key parameter.

According to an embodiment, the predicting of the charging depth of the battery cell based on the estimated value of the key parameter may further include predicting the charging depth based on the profile.

### ADVANTAGEOUS EFFECTS

The charging management apparatus and operating method thereof according to the embodiments disclosed in this document are advantageous in terms of managing rapid charging by predicting the rapid charging depth for minimizing battery degradation.

The charging management apparatus and operating method thereof according to the embodiments disclosed in this document are advantageous in terms of managing rapid charging by predicting the rapid charging depth for minimizing battery deterioration in consideration of the degradation level of the battery.

In addition, various effects identified directly or indirectly through this document can be provided.

### DESCRIPTION OF DRAWINGS

FIG. 1 is a diagram illustrating a charging management system according to an embodiment disclosed in this document;
FIG. 2 is a block diagram a block diagram illustrating the configuration of a charging management apparatus according to an embodiment disclosed in this document;
FIG. 3 is a flowchart illustrating the operation of a charging management apparatus according to an embodiment disclosed in this document;
FIG. 4 is a flowchart illustrating the operation of a key parameter selection unit according to an embodiment disclosed in this document;
FIGS. 5a to 5c are diagrams illustrating the operation of a key parameter selection unit according to an embodiment disclosed in this document;
FIG. 6 is a diagram illustrating the operation of the key parameter selection unit according to an embodiment disclosed in this document;
FIG. 7 is a flowchart illustrating the operation of a depth prediction unit according to an embodiment disclosed in this document; and
FIG. 8 is a flowchart illustrating the operation of a depth prediction unit according to an embodiment disclosed in this document.

### MODE FOR INVENTION

Hereinafter, various embodiments of the present invention will be described with reference to accompanying drawings. However, the description is not intended to limit the present invention to particular embodiments, and it should be construed as including various modifications, equivalents, and/or alternatives of the embodiments described herein.

The various embodiments and terms used in this document are not intended to limit the technical features disclosed in this document to specific embodiments, and should be understood to encompass various modifications, equivalents, or alternatives to the disclosed embodiments. In connection with the description of the drawings, like reference numbers may be used for like or related elements. The singular form of a noun corresponding to an item may include one item or a plurality of items unless the relevant context clearly dictates otherwise.

In this document, each of the phrases such as "A or B", "at least one of A and B", "at least one of A or B", "A, B or C", "at least one of A, B and C", and "at least one of A, B, or C" may include any of the items listed together in the corresponding phrase or any possible combination thereof. Terms such as "the first", "the second", "first", "second", "A", "B", "(a)", or "(b)" may be used simply to distinguish such components from other components and do not limit the corresponding components in other aspects (e.g., importance or order) unless otherwise stated specifically.

In this document, when it is mentioned that a (e.g., first) component is "connected", "coupled", "accessed", with or without the terms "functionally" or "communicatively", to another (e.g., second) component, it means that the component can be connected to the other component directly (e.g., wired), wirelessly, or via a third component.

The methods according to various embodiments disclosed in this document can be included and provided in a computer program product. The computer program product may be traded between sellers and buyers as commodities. The computer program product may be distributed in the form of a machine-readable storage medium (e.g., compact disc read only memory (CD-ROM)) or online (e.g., download or upload) via an application store or directly between two user devices. In the case of online distribution, at least part of the computer program product may be temporarily stored or temporarily created in a device-readable storage medium such as a manufacturer's server, an application store server, or a relay server's memory.

According to various embodiments, each of the described components (e.g., modules or programs) may include one or more entities, and some of the plurality of entities may be separately arranged in other components. According to various embodiments, one or more components or operations may be omitted, or one or more other components or operations may be added. Alternatively or additionally, a plurality of components (e.g., modules or programs) may be integrated into a single component. In this case, the integrated component may perform one or more functions of each of the plurality of components identically or similarly to those performed by the corresponding component of the plurality of components prior to the integration. According to various embodiments, operations performed by modules, programs, or other components are executed sequentially, in parallel, iteratively, or heuristically, or one or more of the operations are executed in a different order, omitted, or one or more other operations may be added.

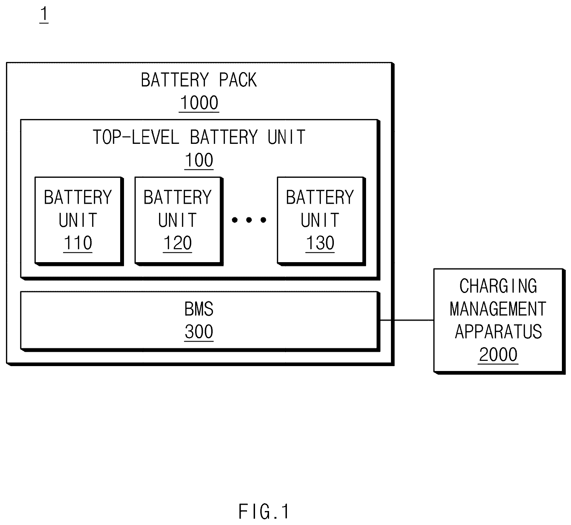

FIG. 1 is a diagram illustrating a charging management system according to an embodiment disclosed in this document.

With reference to FIG. 1, the charging system 1 may include a battery pack 1000 and a charging management apparatus 2000.

According to an embodiment, the battery pack 1000 may include a top-level battery unit 100 and a battery management system 300.

The top-level battery unit 100 may include a plurality of battery units 110, 120, and 130. For example, when the top-level battery unit 100 is a battery module, the plurality of battery units 110, 120, and 130 may be a plurality of battery cells. For example, the plurality of battery units 110, 120, and 130 may include, but is not limited to, lithium-ion (Li-ion) batteries, lithium-ion polymer (Li-ion polymer) batteries, nickelcadmium (Ni-Cd) batteries, and nickel-metal hydride (Ni-MH) batteries.

While FIG. 1 depicts a single top-level battery unit 100, the battery pack 1000 is not limited to this configuration and may include n (where n is a natural number greater than or equal to 2) top-level battery units. Furthermore, certain components may be omitted from the battery pack 1000, or additional generic components may be included.

The top-level battery unit 100 can supply power to a target device (not shown). To achieve this, the top-level battery unit 100 may be electrically connected to the target device. Here, the target device may include any electrical, electronic, or mechanical device that operates by receiving power from the battery pack 1000, which includes the top-level battery unit 100. For example, the target device may be an electric vehicle (EV) or an energy storage system (ESS), but is not limited thereto.

The battery management system (BMS) 300 may manage and/or control the status and/or operation of the top-level battery unit 100 and/or each of the plurality of battery units 110, 120, and 130.

For convenience of explanation, hereinafter, the top-level battery unit 100 and/or each of the plurality of battery units 110, 120, and 130 will be referred to as battery unit 110; however, this reference is equally applicable to the other battery units 120 and 130, as well as to the top-level battery unit 100.

According to an embodiment, the battery management system 300 may determine the status of the battery unit 110 and, based on this, manage the status of the battery unit 110. According to an embodiment, the battery management system 300 may control the operation of the battery unit 110 and, based on this, manage the operation of the battery unit 110.

According to an embodiment, the battery management system 300 may monitor the voltage, current, and/or temperature of the battery unit 110. For monitoring purposes, sensors or various measurement modules that are not shown may be additionally installed at any location such as the top-level battery unit 110, the charge and discharge path, or among the plurality of battery units 110, 120, and 130 included in the top-level battery unit 110.

According to an embodiment, the battery management system 300 may calculate battery information related to the status of the battery unit 110 based on measurements such as voltage, current, and temperature. For example, the battery information related to the status of the battery unit 110 may include at least one of state of charge (SOC), state of health (SOH), resistance, current cycles, predicted remaining cycles, and C-rate.

According to an embodiment, the battery management system 300 may include an on-board diagnostic (OBD) device. Such OBD devices may include not only OBD-I, OBD 1.5, and OBD-II but also various devices that output information related to the status of the battery unit 110 to other devices (e.g., charging management apparatus 2000). Additionally, the operation of the battery management system 300 may be performed on various devices such as a servers, cloud services, chargers, or charge/discharge devices connected to the battery management system 300 or the vehicle equipped with battery management system 300.

According to an embodiment, the charging management apparatus 2000 may receive various information obtained through the battery management system 300 and manage the charging of the battery unit 110 based on the received information. For example, the charging management apparatus 2000 may predict the charging depth related to optimized rapid charging of the battery unit 110. Here, the term "optimized rapid charging" can refer to charging that minimizes the degradation of the battery unit 110.

The battery unit 110 may undergo degradation and deterioration due to changes in physicochemical composition during repeated charging and discharging cycles. Additionally, during the rapid charging process, the battery unit 110 may experience accelerated degradation and deterioration. For example, on the cathode side of the battery unit 110, electrolyte oxidation or structural disruption may cause degradation/deterioration, while on the anode side, metal lithium ions may precipitate (i.e., lithium plating) and lead to degradation/deterioration of the battery unit 110. Therefore, the charging management apparatus 2000 may predict charging conditions that minimize such degradation and deterioration of the battery unit 110. For example, the charging management apparatus 2000 may predict the rapid charging depth that minimizes degradation and deterioration of the battery unit 110. Here, the charging depth may refer to the point at which lithium plating occurs. By determining this limit, the charging management apparatus 2000 can rapidly charge the battery unit 110 without inducing lithium plating.

According to an embodiment, the charging management apparatus 2000 may predict the rapid charging depth based on the degradation level of the battery unit 110. For example, the charging management apparatus 2000 may predict the rapid charging depth reflecting the degradation level of the battery unit 110 based on the degradation state of the battery unit 110 resulting from charge and discharge cycles. Here, the charging management apparatus 2000 may predict the rapid charging depth based on a plurality of parameters related to the physical and chemical properties of the battery unit 110.

According to an embodiment, the charging management apparatus 2000 may analyze parameters that affect the charging depth or rapid charging depth of the battery unit 110. Thus, the charging management apparatus 2000 may determine the optimal temperature and the optimal C-rate for the SOC of the battery unit 110 that minimize degradation during the charging period of the battery unit 110.

According to an embodiment, parameters that affect the rapid charging depth of the battery unit 110 may be obtained by the battery management system 300 and transmitted to and stored by the charging management apparatus 2000. The operation of the charging management apparatus 2000 may be performed on various devices such as servers, cloud services, chargers, or charge/discharge devices connected to the battery management system 300 or the vehicle equipped with the battery management system 300. Hereinafter, the details of the charging depth prediction performed by the charging management apparatus 2000 according to an embodiment will be described in detail with reference to accompanying drawings.

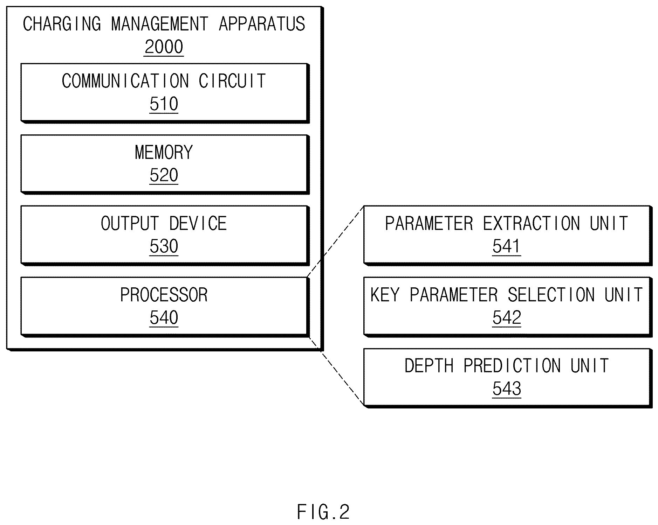

FIG. 2 is a block diagram a block diagram illustrating the configuration of a charging management apparatus according to an embodiment disclosed in this document.

With reference to FIG. 2, the charging management apparatus 2000 may include a communication circuit 510, a memory 520, an output device 530, and a processor 540. However, this is merely illustrative, and various embodiments are not limited to this configuration. For example, at least one of the components of the aforementioned charging management apparatus 2000 may be omitted, or one or more additional components (e.g., input devices, at least one sensor, power management devices, etc.) may be added to the configuration of the charging management apparatus 2000. Additionally, at least one of the aforementioned components may be integrated with other components.

According to an embodiment, the communication circuit 510 may establish wired and/or wireless communication channels between the charging management apparatus 2000 and other devices, and may transmit and receive data through the established communication channels. According to an embodiment, the communication circuit 510 may receive data from a communication module (not shown) included in the battery management system 300. For example, the communication circuit 510 of the charging management apparatus 2000 may receive data related to the battery unit 110. Here, data related to the battery unit 110 may include at least one of type data of the battery unit 110, usage cycle data, voltage data, current data, temperature data, resistance data, charging depth data, SOC data, and C-rate data.

According to an embodiment, the connection between the communication circuit 510 of the charging management apparatus 2000 and the communication module (not shown) of the battery management system 300 may be a communication link via a wired and/or wireless network. In an embodiment, the wired network may be based on local area network (LAN) or power line communication. In an embodiment, the wireless network may be based on a short range communication network (e.g., Bluetooth, wireless fidelity (Wi-Fi), infrared data association (IrDA)) or a long-range communication network (e.g., cellular network encompassing 4G and 5G networks).

According to an embodiment, the connection between the communication circuit 510 of the charging management apparatus 2000 and the communication module (not shown) of the battery management system 300 may be a connection established through an inter-device communication interface (e.g., bus, general purpose input and output (GPIO), serial peripheral interface (SPI), or mobile industry processor interface (MIPI)).

According to an embodiment, the memory 520 may store data used by at least one component of the charging management apparatus 2000 (e.g., processor 540). For example, the data may include software (or related instructions), input data, or output data. In an embodiment, the instructions may be executed by the processor 540 for the charging management apparatus 2000 to perform operations defined by the instructions.

According to an embodiment, the memory 520 may store data acquired from the communication circuit 510. According to an embodiment, the memory 520 may store one or more programs used in mathematical or logical operations performed by the charging management apparatus 2000. For example, the memory 520 may include programs related to ANOVA (analysis of variance) analysis methods or SimBD (Simulator of Battery Dynamics) analysis methods.

According to an embodiment, the memory 520 may include at least one type of storage medium, such as flash memory, hard disk, micro type memory, and card types (e.g., SD card or XD card), random access memory (RAM), static RAM (SRAM), read-only memory (ROM), programmable ROM (PROM), electrically erasable PROM (EEPROM), Magnetic RAM (MRAM), magnetic disks, and optical disks, and various embodiments are not limited to thereto.

According to an embodiment, the output device 530 may output information related to the operation of the charging management apparatus 2000 to the outside of the charging management apparatus 2000. In an embodiment, the output device 530 may include a display configured to output visual information. For example, the display may include at least one of a liquid crystal display (LCD), a thin film transistor liquid crystal display (TFT-LCD), an organic light-emitting diode (OLED) display, a flexible display, a 3-dimensional (3D) display, or a transparent display. Additionally, the display may include a touch sensor configured to detect touch.

However, this is merely illustrative, and various embodiments are not limited to this configuration. For example, information related to the operation of the charging management apparatus 2000 may also be provided as auditory information. In such cases, the output device 530 may further include an audio output device (e.g., a speaker) configured to output sound signals to the outside of the charging management apparatus 2000.

According to an embodiment, the processor 540 may control at least one other component of the charging management apparatus 2000 (e.g., the communication circuit 510, memory 520, and output device 530) and perform various data processing or computational tasks.

According to an embodiment, the processor 540 may execute software stored in the memory 520 to control at least one other component of the charging management apparatus 2000 (e.g., hardware or software components) connected to the processor 540 and perform the operations of the charging management apparatus 2000.

According to an embodiment, the processor 540 may manage the charging depth of the battery unit 110 based on various information obtained through the battery management system 300. For example, the processor 540 may predict the rapid charging depth by reflecting the degradation level of the battery unit 110. In an embodiment, the charging depth may refer to the point at which lithium plating occurs.

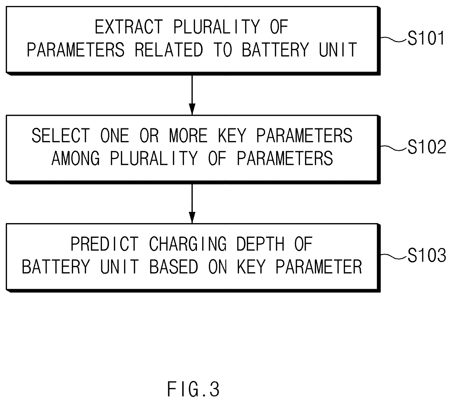

In an embodiment, the processor 540 may include a parameter extraction unit 541, a key parameter selection unit 542, and a depth prediction unit 543. The operations of the parameter extraction unit 541, the key parameter selection unit 542, and the depth prediction unit 543 will be described with reference to FIG. 3.

FIG. 3 is a flowchart illustrating the operation of a charging management apparatus according to an embodiment disclosed in this document.

With reference to FIG. 3, the charging management apparatus 2000 may extract a plurality of parameters related to the battery unit 110 in operation S101 via the parameter extraction unit 541, select one or more key parameters from the plurality of parameters in operation S102 via the key parameter selection unit 542, and predict the charging depth of the battery unit 110 based on the key parameters in operation S103 via the depth prediction unit 543.

In operation S101, the parameter extraction unit 541 may extract a plurality of parameters related to the battery unit 110. For example, the parameter extraction unit 541 may extract parameters used to build a model for predicting the state and/or operation of the battery unit 110. According to an embodiment, when the charging management apparatus 2000 predicts the rapid charging depth of the battery unit 110, the parameter extraction unit 541 may extract parameters used in the rapid charging depth prediction model.

According to an embodiment, the parameters may be characteristic values of the battery unit 110. For instance, parameters for a charging depth prediction model related to degradation of the battery unit 110 may include characteristic values of the battery unit 110 that affect lithium plating (Li Plating), a phenomenon where lithium deposits on the electrodes of the battery unit 110. According to an embodiment, parameters related to lithium plating may include at least one of cathode diffusivity, anode diffusivity, cathode tortuosity, anode tortuosity, cathode rate constant, anode rate constant, cathode conductivity, anode conductivity, and initial electrolyte concentration of the battery unit 110.

In operation S102, the key parameter selection unit 542 may select a set of key parameters related to the battery unit 110. For example, the key parameter selection unit 542 may include parameters that are closely associated with the accuracy of predicting the rapid charging depth of the battery unit 110. These key parameters may be selected from the plurality of parameters extracted by the parameter extraction unit 541.

According to an embodiment, the key parameter selection unit 542 may select as key parameters those parameters used in the prediction model of the charging management apparatus 2000 that are highly correlated with the prediction operation. For example, the key parameter selection unit 542 may select as key parameters the primary parameters that affect the accuracy or performance of the charging depth prediction model from among the plurality of parameters. According to an embodiment, the key parameters may include parameters that strongly influence lithium plating. Alternatively, the key parameters may include parameters associated with the degradation of the battery unit 110.

According to an embodiment, the key parameters may include electrochemical parameters related to the battery unit 110. For example, key parameters may include at least one of diffusivity, tortuosity, conductivity, rate constant for either the cathode or anode, or the initial concentration of the electrolyte.

In operation S103, the depth prediction unit 543 may predict the charging depth of the battery unit 110 based on the selected key parameters. Here, the charging depth may refer to the point at which lithium plating occurs in the battery unit 110. According to an embodiment, the depth prediction unit 543 may predict charging conditions that minimize degradation during the charging phase of the battery unit 110, based on the key parameters. For example, the depth prediction unit 543 may calculate the C-rate corresponding to a predetermined SOC at each temperature of the battery unit 110. By doing so, the depth prediction unit 543 may help minimize the degradation of the battery unit 110 during rapid charging.

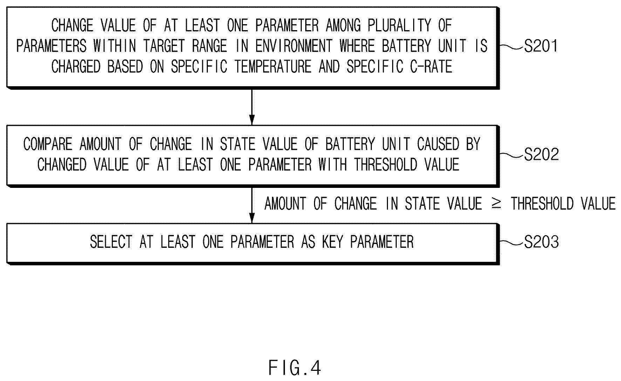

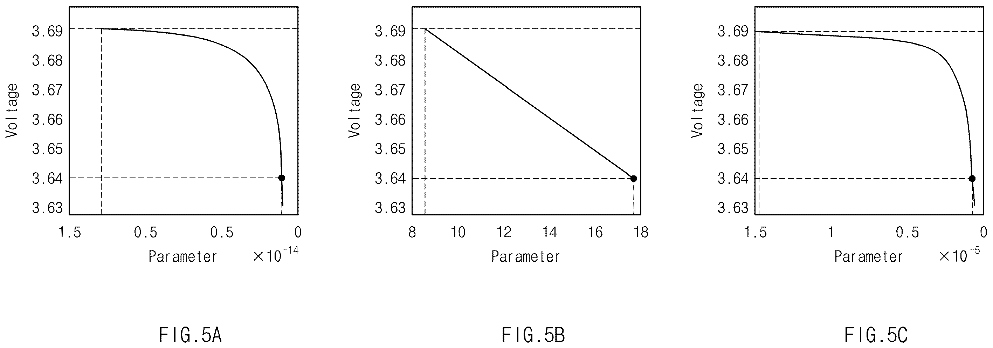

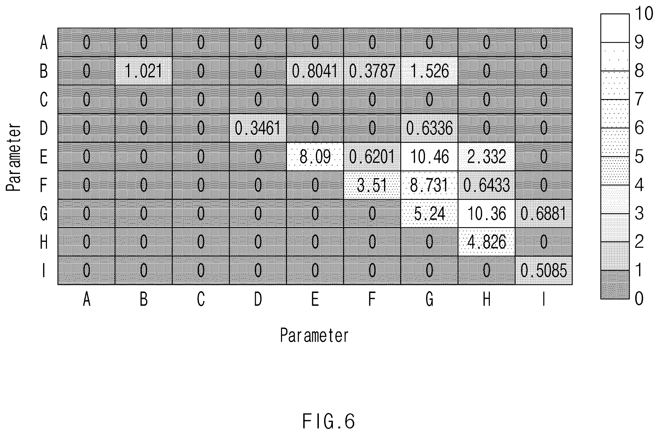

FIG. 4 is a flowchart illustrating the operation of a key parameter selection unit according to an embodiment disclosed in this document. FIGS. 5a to 5c are diagrams illustrating the operation of a key parameter selection unit according to an embodiment disclosed in this document. FIG. 6 is a diagram illustrating the operation of the key parameter selection unit according to an embodiment disclosed in this document.

With reference to FIG. 4, the key parameter selection unit 542 may change the value of at least one parameter among a plurality of parameters in operation S201 within a target range in an environment where the battery unit 110 is charged based on a specific temperature and a specific C-rate, compare the amount of change in the state value of the battery unit 110 in operation S202, caused by the changed value of the at least one parameter, with a threshold value, and select the at least one parameter as a key parameter in operation S203 when the amount of change in the state value of the battery unit 110 is equal to or greater than the threshold value.

In operation S201, the key parameter selection unit 542 may change the value of at least one parameter among a plurality of parameters within a target range in an environment where the battery unit 110 is charged based on a specific temperature and a specific C-rate. Here, the plurality of parameters may be the ones extracted by the parameter extraction unit 541. According to an embodiment, the key parameter selection unit 542 may change the value of at least one parameter among the plurality of parameters within the target range under various environments. These various environments may include any conditions under which the battery unit 110 is charged and discharged. For example, the various environments may include specific temperatures (e.g., 10°C, 25°C, 35°C, etc.), specific C-rates (e.g., 0.5C, 1C, 2C, etc.), specific SOCs (e.g., 0%, 5%, 10%, 15%, ..., 100%, etc.), and various combinations of these factors during charging or discharging periods.

According to an embodiment, the key parameter selection unit 542 may change the value of at least one parameter within a target range in an environment where the battery unit 110 is charged based on a predetermined temperature and a predetermined C-rate. Through this process, the key parameter selection unit 542 may select key parameters based on information about the parameters of the battery unit 110 in various charging and discharging environments.

According to an embodiment, the target range may be the range within which the value of the parameter changes in accordance with the degradation level of the battery unit 110. The description of the target range is provided with reference to FIGS. 5a to 5c.

With reference to FIGS. 5a to 5c, the relationship between the parameter and voltage is illustrated in graph form. FIG. 5a may illustrate the relationship between parameter E and voltage, FIG. 5b may illustrate the relationship between parameter F and voltage, and FIG. 5c may illustrate the relationship between parameter G and voltage. According to an embodiment, parameters E, F, and G may be key parameters. For example, parameter E may be the anode diffusivity, parameter F may be the anode tortuosity, and parameter G may be the rate constant.

According to an embodiment, the key parameter selection unit 542 may determine a first degradation level based on the extent to which the resistance or voltage of the battery unit 110 changes by a predetermined value, and may determine the target range as the range in which the value of the parameter corresponding to the first degradation level changes.

According to an embodiment, the key parameter selection unit 542 may determine the degradation level of the battery unit 110 based on changes in the voltage, current, or resistance of the battery unit 110. According to an embodiment, the key parameter selection unit 542 may determine the first degradation level of the battery unit 110 based on the increase in resistance or decrease in voltage of the battery unit 110 during the discharge period. For example, the key parameter selection unit 542 may determine the first degradation level as the interval in which the resistance of the battery unit 110 increases by a predetermined amount during the discharge period. Additionally, the key parameter selection unit 542 may determine the first degradation level as the interval in which the voltage of the battery unit 110 decreases by a predetermined amount during the discharge period.

For example, the key parameter selection unit 542 may determine the first degradation level as the condition where the voltage reduction of the battery unit 110 during the discharge period reaches a first change amount (e.g., 0.05V). With reference to FIGS. 5a to 5c, the key parameter selection unit 542 may determine the first degradation level as the range where the voltage of the battery unit 110 decreases by 0.05V, i.e., the range where the voltage of the battery unit 110 changes from 3.69V to 3.64V.

According to an embodiment, the key parameter selection unit 542 may determine the target range as the range within which the value of a parameter corresponding to the first degradation level is changed. Alternatively, the target range may include the range of parameter values that correspond to the first degradation level of the battery unit 110.

For example, with reference to FIG. 5a, parameter E (e.g., anode diffusivity) may have a range of values (e.g., 1.25 to 0.1 x 10^-14) corresponding to a voltage range (e.g., 3.69V to 3.64V). Thus, the target range may include the interval where the value of parameter E (e.g., anode diffusivity) falls within the range of 1.25 to 0.1 × 10^-14.

With reference to FIG. 5b, parameter F (e.g., anode tortuosity) may have a range of values (e.g., 8.5 to 17.8) corresponding to a voltage range (e.g., 3.69V to 3.64V). Therefore, the target range may include the interval where the value of parameter F (e.g., anode tortuosity) falls within the range of 8.5 to 17.8.

With reference to FIG. 5c, parameter G (e.g., anode rate constant) may have a range of values (e.g., 1.5 to 0.1 x 10^-5) corresponding to a voltage range (e.g., 3.69V to 3.64V). Therefore, the target range may include the interval where the value of parameter G (e.g., cathode rate constant) falls within the range of 1.5 to 0.1 x 10^-5.

With reference to FIG. 4 again, in operation S202, the key parameter selection unit 542 may compare the amount of change in the state value of the battery unit 110 caused by the changed value of at least one parameter with a threshold value.

According to an embodiment, the key parameter selection unit 542 may calculate the state value of the battery unit 110 based on the changed value of the parameter. Here, the state value of the battery unit 110 may include the charging depth of the battery unit 110. Additionally, the key parameter selection unit 542 may use a known charging depth prediction method to calculate the charging depth of the battery unit 110. Thus, the key parameter selection unit 542 may determine the charging state value (e.g., charging depth) of the battery unit 110 based on the target range (i.e., range of parameter values) determined in FIGS. 5a to 5c. Subsequently, the key parameter selection unit 542 may compare the amount of change in the state value of the battery unit 110 with a threshold value. The description related to step S202 is provided with reference to FIG. 6.

With reference to FIG. 6, the key parameter selection unit 542 may calculate the amount of change in the state value of the battery unit 110. FIG. 6 may represent the amount of change in the state value with respect to a plurality of parameters (A, B, C, D, E, F, G, H, and I). According to an embodiment, parameter A may represent anode diffusivity, B anode curvature, C anode rate constant, D anode conductivity, E cathode diffusivity, F cathode curvature, G cathode rate constant, H initial electrolyte concentration, and I cathode conductivity.

According to an embodiment, the key parameter selection unit 542 may calculate the amount of change in the state value of the battery unit 110 using a variance analysis method. For example, the key parameter selection unit 542 may use the ANOVA (Analysis of Variance) method to compute the amount of change in the state value of the battery unit 110. The ANOVA method may be used to analyze the characteristics of two different groups by comparing the means and variances of the two groups. According to an embodiment, the amount of change in the state value of the battery unit 110 calculated by the key parameter selection unit 542 may be represented by numbers indicated on the graph in FIG. 6.

According to an embodiment, the key parameter selection unit 542 may modify the values of each of the plurality of parameters within the target range and compute the amount of change in the state value of the battery unit 110. Here, the state value of the battery unit 110 may include the charging depth of the battery unit 110.

According to an embodiment, the key parameter selection unit 542 may modify the value of at least one parameter among a plurality of parameters within the target range during the charging period at a predetermined temperature (e.g., 25°C) and a predetermined C-rate (e.g., 1C). Here, the target range may vary for each of the plurality of parameters. For example, the range in which the value of parameter E is changed may be the same as the target range of parameter E (e.g., 1.25 to 0.1 × 10^-14), the range in which the value of parameter F is changed may be the same as the target range of parameter F (e.g., 8.5 to 17.8), and the range in which the value of parameter G is changed may be the same as the target range of parameter G (e.g., 1.5 to 0.1 × 10^-5). The key parameter selection unit 542 may then compute the amount of change in the state value of the battery unit 110 caused by the modified value of at least one parameter.

According to an embodiment, the key parameter selection unit 542 may represent the amount of change in the state value of the battery unit 110 using a grayscale. For example, the amount of the change in the state value of the battery unit 110 may be represented on a grayscale ranging from 0 to 10. This approach allows the key parameter selection unit 542 to quantify the extent to which the specific value of at least one parameter among the plurality of parameters affects the state value of the battery unit 110 (e.g., charging depth).

According to an embodiment, the key parameter selection unit 542 may compare the amount of change in the state value of the battery unit 110 with a threshold value. Here, the threshold value may be a predetermined value. According to an embodiment, the threshold value may be determined by machine learning as the number of operations performed by the key parameter selection unit 542 increases.

With reference to FIG. 4 again, in operation S203, the key parameter selection unit 542 may select a parameter as a key parameter when the amount of change in the state value of the battery unit is equal to or greater than the threshold value. This allows the key parameter selection unit 542 to identify at least one parameter that significantly impacts the state value of the battery unit (e.g., charging depth) as a key parameter. According to an embodiment, the selected key parameters may include parameters related to the anode of the battery cell. For example, the selected key parameters may include at least one of the diffusivity, tortuosity, or rate constant of the anode of the battery cell.

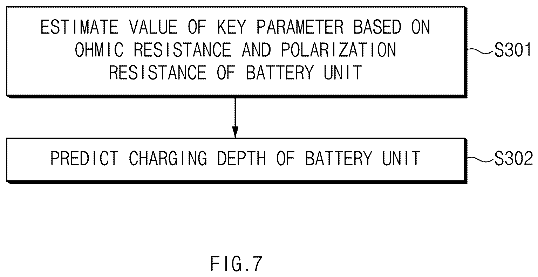

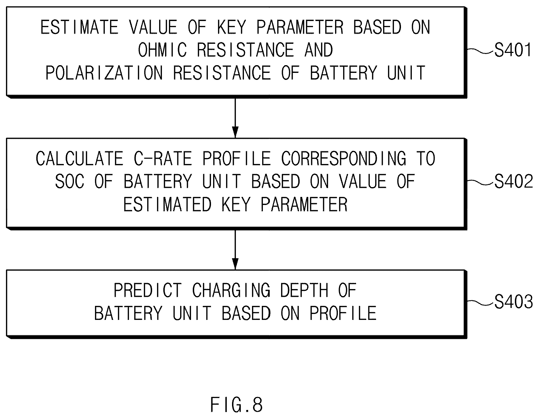

FIG. 7 is a flowchart illustrating the operation of a depth prediction unit according to an embodiment disclosed in this document. FIG. 8 is a flowchart illustrating the operation of a depth prediction unit according to an embodiment disclosed in this document.

With reference to FIG. 7, the depth prediction unit 543 may estimate the value of the key parameters based on the ohmic resistance and polarization resistance of the battery unit 110 in operation S301 and predict the charging depth of the battery unit 110 in operation S302.

According to an embodiment, the depth prediction unit 543 may manage the charging depth of the battery unit 110 based on the state of the battery unit 110. According to an embodiment, the depth prediction unit 543 may predict the charging depth of the battery unit 110 based on the key parameters. For example, the depth prediction unit 543 may predict the charging depth that minimizes the degradation of the battery unit 110.

In step S301, the depth prediction unit 543 may estimate the values of the key parameters selected by the key parameter selection unit 542. The key parameters may include electrochemical parameters related to the battery unit 110. For example, key parameters may include at least one of diffusivity, tortuosity, conductivity, rate constant for either the cathode or anode, or the initial concentration of the electrolyte. The values of such key parameters may be impossible to measure without damaging the battery. However, the depth prediction unit 543 may estimate the values of these key parameters in a non-destructive manner.

According to an embodiment, the depth prediction unit 543 may estimate the values of key parameters using a simulator for the battery unit 110. For example, the depth prediction unit 543 may use the SimBD (Simulator of Battery Dynamics) analysis method to estimate these values. The SimBD analysis method may include a simulator that calculates the pseudo-2D governing equations using numerical techniques. Here, the pseudo-2D governing equation may be an equation that incorporates factors related to the depth direction of the battery cell region of the battery unit 110 and the radius direction of each lithium-ion particle.

According to an embodiment, the depth prediction unit 543 may train a cost function used in the simulator based on the key parameters. Here, the cost function refers to a function used to train the simulator for predicting the charging depth. According to an embodiment, the cost function may include a plurality of parameters. For example, the cost function may encompass design parameters related to the design values of the battery cell in the battery unit 110 and a plurality of parameters extracted by the parameter extraction unit 541. According to an embodiment, the cost function may include key parameters.

The depth prediction unit 543 may estimate the values of key parameters by training the cost function based on various resistances of the battery unit 110. According to an embodiment, the depth prediction unit 543 may estimate the values of key parameters based on the ohmic resistance and polarization resistance of the battery unit 110. Here, ohmic resistance and polarization resistance may refer to the internal resistances of the battery unit 110. For example, ohmic resistance may refer to the resistance generated by the movement of electrons in the current collector, separator, and electrodes of the battery unit 110, while diffusion resistance may refer to the resistance generated in the internal capacitor of the battery unit 110 during electrochemical reactions.

According to the embodiment, the battery management system 300 may calculate the ohmic resistance through the voltage change immediately after current is applied to the battery unit 110 (e.g., 0 to 1 second), and may calculate the polarization resistance through the voltage change from a specific time (e.g., 1 to 30 seconds) thereafter. Ohmic resistance and polarization resistance may be calculated through a resistance measurement method (e.g., HPPC test). According to the embodiment, the battery management system 300 may calculate the ohmic resistance and polarization resistance during the discharge period of the battery unit 110. Consequently, the depth prediction unit 543 of the charge management apparatus 2000 may obtain the ohmic resistance and polarization resistance from the battery management system 300.

According to an embodiment, the depth prediction unit 543 may estimate the value of the key parameter by giving greater weight to the polarization resistance of the battery unit 110 compared to the ohmic resistance of the battery unit 110. For example, the depth prediction unit 543 may increase the proportion of the polarization resistance in the cost function compared to the proportion of the ohmic resistance, thereby giving higher weight to the polarization resistance when calculating the cost function. Thus, the depth prediction unit 543 may estimate the value of the key parameter based on the cost function. This allows the depth prediction unit 543 to accurately predict the state of charge of the battery unit 110 using the voltage or resistance obtained during the discharge period.

In operation S302, the depth prediction unit 543 may predict the charging depth of the battery unit 110 based on the estimated values of the key parameters. For example, the depth prediction unit 543 may use known charging depth prediction methods to predict the state of charge of the battery unit 110. According to an embodiment, the depth prediction unit 543 may predict the metal charging depth that minimizes degradation during rapid charging of the battery unit 110 based on the estimated values of the key parameters. The operation S302 of predicting the charging depth by the depth prediction unit 543 will be described in detail with reference to FIG. 8.

With reference to FIG. 8, the depth prediction unit 543 may estimate the values of key parameters based on the ohmic resistance and polarization resistance of the battery unit 110 in operation S401, calculate a C-rate profile corresponding to the SOC of the battery unit 110 based on the estimated values of the key parameters in operation S402, and predict the charging depth of the battery unit 110 in operation S403.

In operation S401, the depth prediction unit 543 may estimate the values of key parameters based on the ohmic resistance and polarization resistance of the battery unit. A detailed description of the operation of the depth estimation unit 543 in estimating the values of the key parameters is provided with reference to FIG. 7 and thus will be omitted here.

In operation S402, the depth prediction unit 543 may calculate a C-rate profile corresponding to the SOC of the battery unit 110 based on the estimated values of the key parameters. For example, the depth prediction unit 543 may calculate C-rates (e.g., 0.5C, 1C, and 2C) corresponding to specific SOC levels (e.g., 20%, 40%, 60%, 80%, and 100%). Here, the depth prediction unit 543 may generate C-rate profiles corresponding to the SOC for each temperature (e.g., 0°C, 5°C, 10°C, 25°C, and 35°C).

In operation S403, the depth prediction unit 543 may predict the charging depth of the battery unit 110 based on the C-rate profile corresponding to the SOC of the battery unit 110. According to the embodiment, for each temperature (e.g., 10°C, 25°C, and 35°C), the depth prediction unit 543 may predict the amount of current required to charge the battery unit 110 to a specific SOC (e.g., 20%) based on the calculated C-rate (e.g., 0.5C, 1C, and 2C) corresponding to that SOC. This allows the charging management apparatus 2000 to charge the battery unit 110 with different C-rates according to the SOC of the battery unit 110. Consequently, the depth prediction unit 543 can manage the charging depth of the battery unit 110 to maintain optimal performance, ensuring that lithium plating does not occur.

Although all components are described as being combined or operating as one, the embodiments disclosed in this document are not limited to these examples. That is, within the scope of the embodiments disclosed in this document, all of the components may also be selectively combined in one or more ways to function.

Furthermore, terms such as "comprise," "include," or "have" as used above should be interpreted to imply the inclusion of the specified components unless specifically stated otherwise, rather than excluding other components, and may include additional components. Unless otherwise defined, all terms, including technical or scientific terms used herein, have the same meanings as commonly understood by those skilled in the art to which the embodiments disclosed in this invention belong. It will be further understood that terms, such as those defined in commonly used dictionaries, should be interpreted as having a meaning that is consistent with their meaning in the context of the relevant art and should not be interpreted in an idealized or overly formal sense unless expressly so defined herein.

The above-described disclosure provides a general overview of certain features of several embodiments to help those skilled in the art better understand the aspects of the disclosure. It will be appreciated that those skilled in the art can readily use the disclosure as a basis to design or modify other structures to achieve the same objectives or benefits as the embodiments introduced herein. Additionally, it will be understood by those skilled in the art that various modifications, alternatives, and adjustments can be made within the scope of the disclosure as described in this specification.

## Claims

1. A charging management apparatus comprising:
a parameter extraction unit configured to extract a plurality of parameters related to a battery cell;
a key parameter selection unit configured to select one or more key parameters from the plurality of parameters; and
a depth prediction unit configured to predict the charging depth of the battery cell based on the key parameters.

2. The charging management apparatus of claim 1, wherein the key parameter selection unit modifies the value of at least one parameter among the plurality of parameters within a target range in an environment where the battery cell is charged based on a predetermined temperature and a predetermined C-rate, and selects the at least one parameter as the key parameter when the amount of change in a state value of the battery cell, based on the modified value of the at least one parameter, is equal to or greater than a threshold value.

3. The charging management apparatus of claim 2, wherein the target range is a range of values of the at least one parameter corresponding to a first degradation level of the battery cell.

4. The charging management apparatus of claim 3, wherein the key parameter selection unit determines the first degradation level based on an increase in resistance or a decrease in voltage of the battery cell during a discharge period.

5. The charging management apparatus of claim 1, wherein the key parameter comprises at least one of diffusivity, tortuosity, and rate constant related to an anode of the battery cell.

6. The charging management apparatus of claim 1, wherein the depth prediction unit estimates the value of the key parameter based on the ohmic resistance and polarization resistance of the battery cell during the discharge period, and predicts the charging depth of the battery cell based on the estimated value of the key parameter.

7. The charging management apparatus of claim 6, wherein the depth prediction unit estimates the value of the key parameter by giving a greater weight to the polarization resistance of the battery cell than to the ohmic resistance of the battery cell.

8. The charging management apparatus of claim 6, wherein the depth prediction unit calculates a C-rate profile corresponding to the state of charge (SOC) of the battery cell based on the estimated value of the key parameter, and predicts the charging depth of the battery cell based on the profile.

9. A charging management method comprising:
extracting a plurality of parameters related to a battery cell;
selecting one or more key parameters from among the plurality of parameters; and
predicting the charging depth of the battery cell based on the key parameters.

10. The charging management method of claim 9, wherein the selecting of one or more key parameters from among the plurality of parameters comprises:
modifying the value of at least one parameter among the plurality of parameters within a target range in an environment where the battery cell is charged based on a predetermined temperature and a predetermined C-rate; and
selecting the at least one parameter as the key parameter when the amount of change in a state value of the battery cell, based on the modified value of the at least one parameter, is equal to or greater than a threshold value.

11. The charging management method of claim 10, wherein the target range is a range of values of the at least one parameter corresponding to a first degradation level of the battery cell.

12. The charging management method of claim 11, wherein the selecting of one or more key parameters from among the plurality of parameters further comprises determining the first degradation level based on an increase in resistance or a decrease in voltage of the battery cell during a discharge period.

13. The charging management method of claim 9, wherein the key parameter comprises at least one of diffusivity, tortuosity, and rate constant related to an anode of the battery cell.

14. The charging management method of claim 9, wherein the predicting of the charging depth of the battery cell comprises:
estimating the value of the key parameter based on the ohmic resistance and polarization resistance of the battery cell during the discharge period; and
predicting the charging depth of the battery cell based on the estimated value of the key parameter.

15. The charging management method of claim 14, wherein the predicting of the charging depth of the battery cell comprises estimating the value of the key parameter by giving a greater weight to the polarization resistance of the battery cell than to the ohmic resistance of the battery cell.

16. The charging management method of claim 14, wherein the predicting of the charging depth of the battery cell further comprises calculating a C-rate profile corresponding to the state of charge (SOC) of the battery cell based on the estimated value of the key parameter.

17. The charging management method of claim 16, wherein the predicting of the charging depth of the battery cell based on the estimated value of the key parameter further comprises predicting the charging depth based on the profile.
